# EUROPÄISCHE PATENTSCHRIFT

(11) **EP 2 596 525 B1**
(45) Veröffentlichungstag und Bekanntmachung des Hinweises auf die Patenterteilung: **15.04.2015**
(21) Anmeldenummer: 10737783.0
(22) Anmeldetag: 23.07.2010
(51) Int. Cl.: H01L 21/687, H01L 21/683

(54) **HANDHABUNGSVORRICHTUNG ZUR HANDHABUNG EINES WAFERS**
HANDLING DEVICE FOR HANDLING A WAFER
DISPOSITIF DE MANIPULATION DESTINÉ À MANIPULER UNE TRANCHE

(43) Veröffentlichungstag der Anmeldung: 29.05.2013
(73) Patentinhaber: EV Group GmbH, 4782 St. Florian am Inn (AT)
(72) Erfinder: BRANDSTÄTTER, Ingo, A-4794 Kopfing im Innkreis (AT); WAGENLEITNER, Thomas, A-4971 Aurolzmünster (AT); SCHMIDBAUER, Martin, A-4761 Enzenkirchen (AT)
(74) Vertreter: Schweiger, Johannes
(86) Internationale Anmeldenummer: PCT/EP2010/004528
(87) Internationale Veröffentlichungsnummer: WO 2012/010186

(56) Entgegenhaltungen:
- WO-A2-02/29856
- US-A- 5 423 716
- US-A1- 2007 026 772

## Beschreibung

Die vorliegende Erfindung betrifft eine Handhabungsvorrichtung zur Handhabung eines Wafers beim Bearbeiten des Wafers gemäß Patentanspruch 1.

Zur Handhabung von Wafern gibt es verschiedene Vorrichtungen und auf Grund der immer dünner werdenden Wafer sowie gleichzeitig steigender Durchmesser der Wafer von bis zu 450 mm gewinnen Handhabungsvorrichtungen für Wafer immer größere Bedeutung, insbesondere dann, wenn die Wafer bereits mit teuren Strukturen bestückt sind.

Zum Fixieren von Wafern sind mechanische Verfahren bekannt, bei welchen auch gleichzeitig die mechanische Beanspruchung des Wafers, insbesondere am Druckpunkt von mechanischen Klemmen, ein gravierendes technisches Problem darstellt.

Die US 2007/0026772 A1 beschreibt eine gattungsgemäße Vorrichtung zur Verwendung beim Bearbeiten eines Halbleiterwerkstücks.

Das Fixieren von Wafern mittels chemischer Verfahren wie Kleben oder durch Adhäsion führt zu einer oft sehr festen Haftung zwischen dem Probenhalter beziehungsweise Trägerwafer und dem Wafer. Die so hergestellten Verbindungen müssen meist chemisch gelöst werden, was ein umweltschädlicher und langwieriger Prozess ist.

Das Fixieren von Wafern mittels elektrostatischer Aufladung führt zu teilweise ungewollter Entladung des Trägers und/oder des Wafers.

In der US 4,667,944 ist eine Handhabungsvorrichtung für Halbleiterchips 12 offenbart, bei der ein Textilgewebe 16 auf einem Träger 10 von einer flexiblen Abdeckung 18 bedeckt wird, an der ein Chip 12 haftbar ist. Die Haftkraft kann durch Anlegen eines Vakuums an der Kontaktfläche zwischen dem flexiblen Film 18 reduziert werden.

Die Aufgabe der vorliegenden Erfindung besteht darin, eine Handhabungsvorrichtung für die Handhabung von Wafern anzugeben, mit welcher eine sichere und einfache Handhabung eines Wafers auf möglichst schonende und zerstörungsfreie Art und Weise ermöglicht wird. Darüber hinaus soll das technische Problem gelöst werden, dass der Wafer rückstandsfrei von der Handhabungsvorrichtung lösbar ist, ohne den Wafer zu beschädigen und ohne großen Kraftaufwand.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zu Grunde, auf eine Handhabungsvorrichtung einen den Wafer nur teilweise stützenden Abstandhalter vorzusehen, der mittels einer Abdeckung, insbesondere einer Abdeckfolie und durch Anlegen eines Unterdrucks gegenüber der Umgebung so ausgebildet ist, dass die Kontaktfläche der Abdeckfolie mit dem Wafer verringerbar ist. Hierdurch wird die Adhäsionskraft reduziert, so dass der Wafer auf einfache Art und Weise und zerstörungsfrei sowie rückstandsfrei von der Abdeckung abgenommen werden kann. Gleichzeitig ist die Handhabung umweltschonend allein durch Druckveränderung und damit gleichzeitig energetisch besonders sparsam.

Der erfindungsgemäße Träger erlaubt es, ultradünne Wafer, insbesondere Wafer mit Bauteilen auf der Oberfläche, in Bereichen ohne Bauteile auf der Oberfläche zu fixieren, so dass die besonders empfindlichen und teuren Teile des Wafers geschont werden und eine Fixierung des Wafers, insbesondere am Rand, in Bereichen möglich ist, die möglicherweise sogar speziell hierfür vorgesehen sind. Dadurch kann der Wafer rückstandsfrei, ohne Beschädigung und mit extrem geringem Kraftaufwand von dem Träger beziehungsweise der adhäsiven Abdeckung entfernt werden. Besonders vorteilhaft ist es, dass die Handhabungsvorrichtung wieder verwendbar ist, insbesondere für mehr als 10, vorzugsweise mehr als 100, besonders bevorzugt mehr als 1000 Handhabungsvorgänge.

Gemäß einer vorteilhaften Ausführungsform der Erfindung ist vorgesehen, dass die Rasterstruktur ringförmig, insbesondere kreisringförmig, vorzugsweise mit einem Verhältnis der Ringbreite B zum Durchmesser D der Rasterstruktur von weniger als 1:5, insbesondere weniger als 1:10, vorzugsweise weniger als 1:15, ausgebildet ist. Hierdurch wird eine gleichmäßige Fixierung und besonders einfaches Lösen des Wafers von der ringförmigen Abdeckung der Rasterstruktur ermöglicht.

Soweit die Abdeckung eine, insbesondere adhäsive, Folie, vorzugsweise eine Gelfolie ist, erfolgt die Handhabung, insbesondere das Lösen des Wafers, auf einfache Art und Weise ohne chemische Lösungsmittel oder ohne Temperatureinfluss, so dass hierdurch die Ressourcen geschont werden. Besonders geeignet als Material für die Folie ist PDMS (Polydimenthylsiloxan) oder PFPE (Perfluorpolyether).

Gemäß einer weiteren, vorteilhaften Ausführungsform der Erfindung ist vorgesehen, dass die Fixierung ausschließlich in einem Bereich des Wafers ohne erhabene Strukturen, insbesondere am Rand des Wafers, erfolgt. Auf diese Weise werden die erhabenen Strukturen des Wafers geschont und eine spannungsfreie Aufnahme des Wafers ermöglicht.

Als eigenständige Erfindung ist eine Verwendung der Handhabungsvorrichtung innerhalb von Waferbehandlungsvorrichtungen anzusehen, die bei Unterdruck Wafer bearbeiten. Dabei ist es insbesondere vorteilhaft, wenn der Rasterraum mit einem höheren Unterdruck als der Unterdruck in der Waferbehandlungsvorrichtung beaufschlagbar ist.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1:: eine schematische Aufsicht auf einen bestückten Wafer,
- Fig. 2a:: eine schematische Aufsicht auf eine erfindungsgemäße Handhabungsvorrichtung,
- Fig. 2b:: eine schematische Seitenansicht gemäß Schnittlinie A-A aus Figur 2a,
- Fig. 3a:: eine vergrößerte, schematische Schnittansicht der erfindungsgemäßen Rasterstruktur in einer Fixierstellung und
- Fig. 3b:: eine vergrößerte, schematische Schnittansicht der erfindungsgemäßen Rasterstruktur in einer Lösestellung.

In den Figuren sind gleiche Bauteile und Bauteile mit der gleichen Funktion mit den gleichen Bezugszeichen gekennzeichnet.

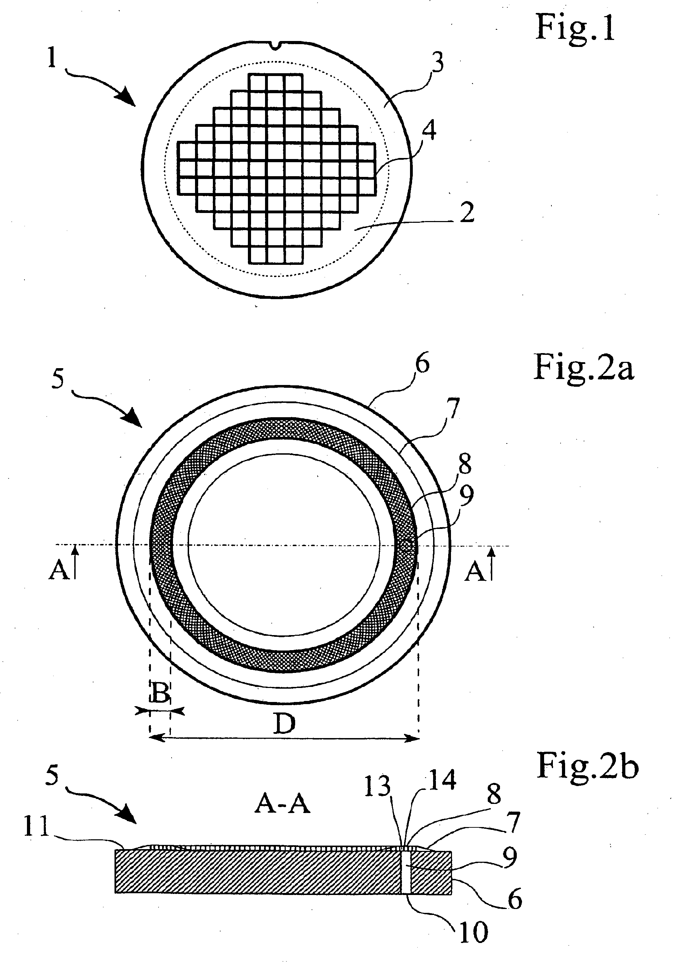

Figur 1 zeigt einen Wafer 1 mit einem Bereich des Wafers 1 mit erhabenen Strukturen 4, insbesondere Chips, sowie einem Bereich des Wafers 1 ohne erhabene Strukturen, nämlich einem Randbereich 3 des Wafers 1, der für die Fixierung des Wafers 1 an einer in Figur 2a gezeigten Handhabungsvorrichtung 5 dient. Die erhabenen Strukturen 4 sind auf einer Waferaufnahmeseite 2, die an einer Handhabungsvorrichtung 5 mit dem Randbereich 3 an einer Kontaktfläche 14 in Kontakt tritt.

Die Handhabungsvorrichtung 5 besteht aus einem Träger 6, hier einem Chuck, auf dem eine Rasterstruktur 8 aufgebracht ist, und zwar an einer flächigen Aufnahmeseite 11, die in der in Figur 2b gezeigten Ausrichtung oben ist.

Die Rasterstruktur 8 ist gemäß Figur 2a kreisringförmig und steht von der Aufnahmeseite 11 des Trägers 6 ab. Die Rasterstruktur 8 ist mit dem Träger 6 verbunden, entweder eingelassen, eingeschweißt oder angeklebt. Die Rasterstruktur 8 hat keine geschlossene Oberfläche und ist mit einer als Gelfolie ausgebildeten Abdeckung 7 überzogen und die Abdeckung 7 ist somit ebenfalls ringförmig und in der hier gezeigten Ausführungsform seitlich von der Rasterstruktur 8 am Träger 6, hier an der Aufnahmeseite 11, fixiert und dicht versiegelt. Es ist auch denkbar, dass die Folie die gesamte Aufnahmeseite 11 überdeckt und seitlich oder unten am Träger 6 fixiert ist. Hierdurch wird die Folie zwar stabiler, in der gezeigten Ausführungsform ist die ringförmige Folie jedoch geringeren Verformungen durch die ständige Dehnung unterlegen.

Der Wafer 1 wird zur Handhabung durch die Handhabungsvorrichtung 5 zentrisch auf die Handhabungsvorrichtung 5 gelegt, so dass der Randbereich 3 auf der Rasterstruktur 8 zur Anlage kommt und die erhabenen Strukturen 4 auf dem Wafer 1 in dem durch die Rasterstruktur 8, die Abdeckung 7 und die Aufnahmeseite 11 gebildeten, wannenförmigen Aufnahmeraum 12 aufgenommen sind und dort geschont werden. Damit erfüllt die vorliegende Erfindung gleichzeitig mehrere Aufgaben, nämlich die schonende Handhabung des Wafers 1 und gleichzeitig das einfache Lösen des Wafers 1.

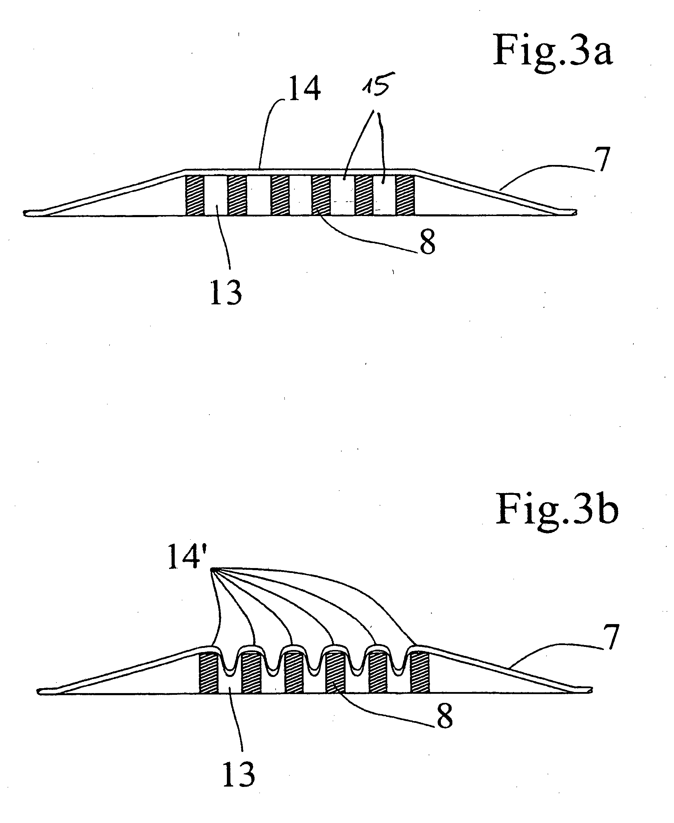

Der Wafer 1 haftet durch die adhäsive Wirkung der Abdeckung 7 an der Abdeckung 7. In einer in Figur 3a gezeigten Fixierstellung der Abdeckung 7 ist die Adhäsionskraft am größten, insbesondere vollflächig zwischen der Kontaktfläche 14 der Abdeckung 7 und dem korrespondierenden Kontaktbereich im Randbereich 3 des Wafers 1.

In der Fixierstellung ist die Abdeckung 7 auf Grund ihrer Flexibilität entlang der Oberseite der Raststruktur 8 gespannt und im Wesentlichen eben.

Ein durch die Abdeckung 7, die Rasterstruktur 8 und die flächige Aufnahmeseite 11 begrenzter Rasterraum 13 ist mittels einer an eine Vakuumleitung 9 angeschlossenen Vakuumeinrichtung 10 mit Unterdruck beaufschlagbar, wobei sich der Unterdruck gleichmäßig entlang der ringförmigen Rasterstruktur 8 auf Grund der Textur der Rasterstruktur 8 verteilt. Die Rasterstruktur 8 ist in vorteilhafter Ausgestaltung gitterartig, kann aber auch aus einzelnen Strukturbestandteilen, insbesondere Kugeln, gebildet sein.

Durch das Anlegen eines Unterdrucks im Rasterraum 13 verformt sich die Abdeckung 7 an ihrer Kontaktfläche 14 an der Oberseite der Rasterstruktur 8, indem die flexible Abdeckung 7 an freien Bereichen 15 der Rasterstruktur 8 in den Rasterraum 13 hineingezogen wird, so dass in einer in Figur 36 gezeigten Lösestellung nur noch die Bereiche der Abdeckung 7 in Kontakt mit dem Wafer 1 sind, die von der Rasterstruktur 8 an der entsprechend kleineren Kontaktfläche 14' gestützt sind. Die Kontaktfläche 14' ist gegenüber der Kontaktfläche 14 deutlich verringert, wodurch gleichzeitig die Adhäsionskraft der Abdeckung 7 gegenüber dem Wafer 1 im Randbereich 3 abnimmt und der Wafer 1 somit auf einfache Art und Weise von der Handhabungsvorrichtung 5 lösbar ist.

Das Verhältnis zwischen der Fläche der Kontaktfläche 14 in der in Figur 3a gezeigten Fixierstellung und der Fläche der Kontaktfläche 14' in der in Figur 3b gezeigten Lösestellung ist größer als 1,5:1, insbesondere 2:1, bevorzugt 3:1.

### Bezugszeichenliste

- 1: Wafer
- 2: Waferaufnahmeseite
- 3: Randbereich
- 4: erhabene Strukturen
- 5: Handhabungsvorrichtung
- 6: Träger
- 7: Abdeckung
- 8: Rasterstruktur
- 9: Leitung
- 10: Vakuumeinrichtung
- 11: flächige Aufnahmeseite
- 12: Aufnahmeraum
- 13: Rasterraum
- 14, 14': Kontaktfläche
- 15: freie Bereiche
- B: Ringbreite
- D: Durchmesser

## Patentansprüche

1. Handhabungsvorrichtung (5) zur Handhabung eines Wafers (1) beim Bearbeiten des Wafers (1) mit folgenden Merkmalen:
- ein Träger (6) mit einer flächigen Aufnahmeseite (11) zur Aufnahme des Wafers (1),
- eine auf der Aufnahmeseite (11) gegenüber der Aufnahmeseite (11) erhabene Struktur, wobei die Struktur und eine Abdeckung (7) mit der Aufnahmeseite (11) einen Aufnahmeraum (12) zur Aufnahme von am Wafer (1) vorgesehenen, gegenüber einer Waferaufnahmeseite (2) erhabenen Strukturen (4) bilden,
**dadurch gekennzeichnet,**
**dass** die Struktur als Rasterstruktur (8) ausgebildet ist und die Abdeckung (7) als eine die Rasterstruktur (8) gegenüber dem Träger (6) dichtend bedeckende, flexible und adhäsive Abdeckung (7) zur Fixierung des Wafers (1) auf dem Träger (6) ausgebildet ist, wobei ein durch die Abdeckung (7) und den Träger (6) begrenzter Rasterraum (13) mit Unterdruck beaufschlagbar ist.

2. Handhabungsvorrichtung (5) nach Anspruch 1, **dadurch gekennzeichnet, dass** die Rasterstruktur (8) ringförmig, insbesondere kreisringförmig, vorzugsweise mit einem Verhältnis der Ringbreite B zum Durchmesser D der Rasterstruktur (8) von weniger als 1:5, insbesondere weniger als 1:10, vorzugsweise weniger 1:15 ausgebildet ist.

3. Handhabungsvorrichtung (5) nach einem der vorhergehenden Ansprüche, **dadurch gekennzeichnet, dass** die Abdeckung (7) eine Folie, vorzugsweise eine Gelfolie, ist.

4. Handhabungsvorrichtung (5) nach einem der vorhergehenden Ansprüche, **dadurch gekennzeichnet, dass** die Fixierung ausschließlich in einem Bereich des Wafers (1) ohne erhabene Strukturen, insbesondere am Rand des Wafers (1), erfolgt.

## Claims

1. Handling device (5) for handling of a wafer (1) in the processing of the wafer (1) with the following features:
- a carrier (6) with a flat receiving side (11) for holding the wafer (1),
- a structure which is raised on the receiving side (11) relative to the receiving side (11), wherein the structure and a cover (7) with the receiving side (11) form a receiving space (12) for holding of structures (4) which are provided on the wafer (1) and which are raised relative to the wafer receiving side (2),
**characterized in that**
the structure is designed as a grid structure (8) and the cover (7) is designed as a flexible and adhesive cover (7) which covers the grid structure (8) relative to the carrier (6), sealing it, for fixing of the wafer (1) on the carrier (6), and wherein a grid space (13) which is bordered by the cover (7) and the carrier (6) can be exposed to negative pressure.

2. Handling device (5) as claimed in Claim 1, wherein the grid structure (8) is made annular, especially in the shape of a circular ring, preferably with a ratio of the ring width B to the diameter D of the grid structure (8) of less than 1:5, especially less than 1:10, preferably less than 1:15.

3. Handling device (5) as claimed in one of the preceding claims, wherein the cover (7) is an especially adhesive film, preferably a gel film.

4. Handling device (5) as claimed in one of the preceding claims, wherein fixing takes place solely in one region of the wafer (1) without raised structures, especially on the edge of the wafer (1).

## Revendications

1. Dispositif de manipulation (5) pour manipuler une tranche (1) lors de l'usinage de la tranche (1), comprenant les attributs suivants :
- un support (6) avec un côté récepteur (11) plan pour recevoir la tranche (1),
- sur le côté récepteur (11), une structure en relief par rapport au côté récepteur (11), sachant que la structure et un couvercle (7) forment avec le côté récepteur (11) un espace récepteur (12) pour recevoir des structures (4) prévues sur la tranche (1), en relief par rapport à un côté récepteur de tranche (2),
**caractérisé en ce que** la structure (8) est formée en tant que structure quadrillée (8) et le couvercle (7) flexible et adhésif, recouvrant de façon étanche la structure quadrillée (8) par rapport au support (6) en conçu en tant que couvercle (7) pour fixer la tranche (1) sur le support (6), sachant qu'un espace quadrillé (13) délimité par le couvercle (7) et le support (6) peut être dépressurisé.

2. Dispositif de manipulation (5) selon la revendication 1, **caractérisé en ce que** la structure quadrillée (8) est annulaire, en particulier en couronne, de préférence avec un rapport de la largeur annulaire B au diamètre D de la structure quadrillée (8) inférieur à 1:5, en particulier inférieur à 1:10, de préférence inférieur à 1:15.

3. Dispositif de manipulation (5) selon la revendication 1 ou 2, **caractérisé en ce que** le couvercle (7) est un film, de préférence un film-gel.

4. Dispositif de manipulation (5) selon l'une des revendications précédentes, **caractérisé en ce que** la fixation s'effectue exclusivement dans une partie de la tranche (1) sans structures en relief, en particulier au bord de la tranche (1).
